Europäisches Patentamt

European Patent Office

Office européen des brevets

(11) Publication number: **0 321 071**

**A1**

(12) # EUROPEAN PATENT APPLICATION

(21) Application number: 88308479.0

(22) Date of filing: 14.09.88

(51) Int. Cl.4: **H01L 39/12 , H01L 39/24**

(30) Priority: **11.12.87 GB 8728970**

(43) Date of publication of application:
**21.06.89 Bulletin 89/25**

(84) Designated Contracting States:
**DE FR GB IT NL**

(71) Applicant: **PLESSEY OVERSEAS LIMITED**
**Vicarage Lane**
**Ilford Essex IGI 4AQ(GB)**

(72) Inventor: **Dorey, Lynn Yvette**
**36 Annesley Close**
**Langlands Northampton(GB)**
Inventor: **Wort, Christopher John**
**1 Valley End Pattishall**
**Towcester Northampton, NN12 8NY(GB)**
Inventor: **Stevenson, Adrian Carl**
**15 Stoke Road**
**Blisworth Northampton, NN7 3BZ(GB)**

(74) Representative: **Lupton, Frederick**
**The Plessey Company plc Intellectual**
**Property Dept. Vicarage Lane**
**Ilford, Essex IG1 4AQ(GB)**

(54) **Method of producing superconducting thin films.**

(57) A method of preparing thin films with the high Tc superconducting composition $Y_1BA_2Cu_3O_{7-\delta}$ from a single ceramic target of the same composition, is described. The technique is based on Ion Beam Sputtering where the plasma generation process is remote from the substrate avoiding unwanted surface plasma interaction effects with the substrate (and growing film) that cause stoichiometry deviations from the target.

## METHOD OF PRODUCING SUPERCONDUCTING THIN FILMS

This invention relates to a method of producing a superconducting thin film.

Until recently, superconductivity was known only in respect of certain materials, for which the BCS theory existed and predicted an upper limit of about 30° K for superconductivity. Experimental work has since found the existence of superconductivity in ceramics with Perovskite lattice structures, as with Lanthanum copper oxide which has a transition temperature of about 48° K. It has also been discovered that the ceramic material yttrium barium copper oxide has a transition temperature of about 93° K, and work is continuing to obtain even higher transition temperatures. It is comparatively easy to fabricate such ceramic material in bulk form, but the material is more useful in thin film form, where it may be fabricated on a suitable substrate for incorporation into an electrical component or integrated circuit device. It has been found possible to form thin films which can carry current densities up to about $10^6$ amp $cm^{-2}$. However problems have been experienced with the fabrication of thin films. A major problem has been to form films with the correct stoichiometric composition, since whereas it has been found that compositions in the form $Y_1Ba_2Cu_3O_{7.\delta}$ have a structure yielding better superconducting properties, it is difficult to ensure that films have this precise composition.

Thus in some attempts, multiple sources have been used comprising individual yttrium, barium and copper metal or oxide sources, and these sources have been individually subjected to evaporation or sputtering mechanisms to produce particles of the individual sources. These particles are deposited on a substrate to form yttrium barium copper oxide material. However it has been found very difficult to adjust the rates at which the particles are produced from the individual sources in order to maintain the correct weight ratio in order to produce the correct stoichiometric composition upon the substrate.

Molecular beam epitaxy has been successfully employed wherein multiple sources are heated under very low pressure conditions in order to produce beams of molecules which are deposited on a substrate. However this method is very expensive.

For this reason it has been found preferable to use a single source of the compound yttrium barium copper oxide and to form particles of this compound by evaporation or sputtering techniques. Nevertheless considerable difficulties are experienced in obtaining the correct stoichiometric composition.

Thus with evaporation techniques such as electron beam evaporation, it has been found that the various components of yttrium barium copper oxide will be evaporated at different rates since the process of evaporation is similar to a boiling technique.

Another known technique is magnetron sputtering wherein an argon plasma is maintained between the target (mounted on a magnetron electrode) and the substrate by means of an RF or DC electric field so that particles sputtered from the target are deposited on the substrate under appropriate conditions. The magnetron electrode reduces secondary electron emission and increases the deposition rate. However the existence of a plasma near the substrate (coupled to the negative DC bias on the target) creates difficulties by forming negative ions (mainly oxygen negative ions) at the substrate. This in turn causes resputtering of components in the deposited film (mainly the barium component). It is therefore difficult to maintain the correct stoichiometric ratios. Hence in order to obtain a film with the correct stoichiometric ratio $Y \cdot Ba_2Cu_3O_x$, it is necessary to use a source of a different composition, e.g. $Y_1Ba_3Cu_4O_{7-\delta}$, but this is only an approximate method of obtaining the correct stoichiometric ratio.

In addition the above processes are found to be highly dependent on temperature and pressure conditions since a change in substrate temperature by as little as 10° C from a median value of 700° C may alter the stoichiometric composition.

In order to overcome the above problems, it has been found that the use of a beam sputtering technique, fast atomic or as preferred ion beam sputtering will yield thin films with the desired stoichiometric ratio from a single ceramic target of the same composition. This is because such sputtering techniques do not require evaporation from a target which may cause changes in composition nor do they rely on a negative DC bias on the target and on the creation of a plasma adjacent the substrate which may give rise to the difficulties noted above. In the ion beam sputtering technique, an ion beam is created remote from the target and a beam of for example argon ions is aimed at the target in order to sputter from the target atoms of the compound from the target, at the same types of energies. By arranging the substrate at a suitable position relative to the incident beam and the target, the sputtered particles may be deposited in sufficient volume on the substrate to form a film. If desired a suitable DC electric bias may be provided between substrate and target to attract the particles to the substrate.

Thus in accordance with the invention, the problems noted above are overcome.

The method according to the invention may be carried out with any suitable superconducting material, metal or ceramic. As preferred, ceramic materials will be in the form $A_aB_bCu_cD_d$, where A is any rare earth, B is barium, strontium or calcium or other elements in Group IIa of the periodic table, and D is oxygen, nitrogen or fluorine or other elements in Period 2. As preferred the ceramic material is $Y_aBa_bCu_cO_d$ where $a = 1$, $b = 2$, $c = 3$ and $d = 7\text{-}\delta$, where $\delta$ is a factor determined empirically by the amount of crystal lattice vacancies required for the correct superconducting properties.

Important advantages of the invention are as follows:-

1. The deposited films with the ion beam sputtering (IBS) have the same composition as the target over a wide range of deposition conditions, unlike other deposition techniques.

2. Substrate modifications (i.e. heating, change of substrate) do not critically affect the deposited film composition. In particular temperatures varying up to 600° C will not affect film composition.

3. The low pressure ($\sim 1 \times 10^{-4}$ torr) IBS technique (cf. magnetron sputtering pressures $\sim 1 \times 10^{-2}$ torr), coupled with energetic sputtering, is particularly suitable to form as-deposited epitaxial thin films of $Y_1Ba_2Cu_3O_{7\text{-}\delta}$ (i.e. films with an oriented crystal lattice structure) on suitable lattice-matched substrates, such as $SrTiO_3$ and LiF. The low pressure coupled with a high arrival energy of atoms leads to greater adatom surface mobility during the nucleation and growth stages of the thin film formation, thus inducing more regularly oriented crystal lattice structures. It also permits the use of lower substrate temperatures.

4. The IBS technique provides uniform deposition of $Y_1Ba_2Cu_3O_{7\text{-}\delta}$ over large substrate areas.

5. Oxide targets can be manufactured with 99.99% purity, enabling films with equivalent purity to be obtained. The purity of films produced from metal targets is limited by the purity of barium (99.2% pure).

6. The low operating pressures ($\sim 10^{-4}$ torr) reduce gas contamination (e.g. Argon, where Argon is used as an ion beam) of the growing film.

A preferred embodiment of the invention will now be described with reference to the single figure of drawings, which is a schematic view of apparatus for carrying out a method of depositing a superconducting film according to the invention.

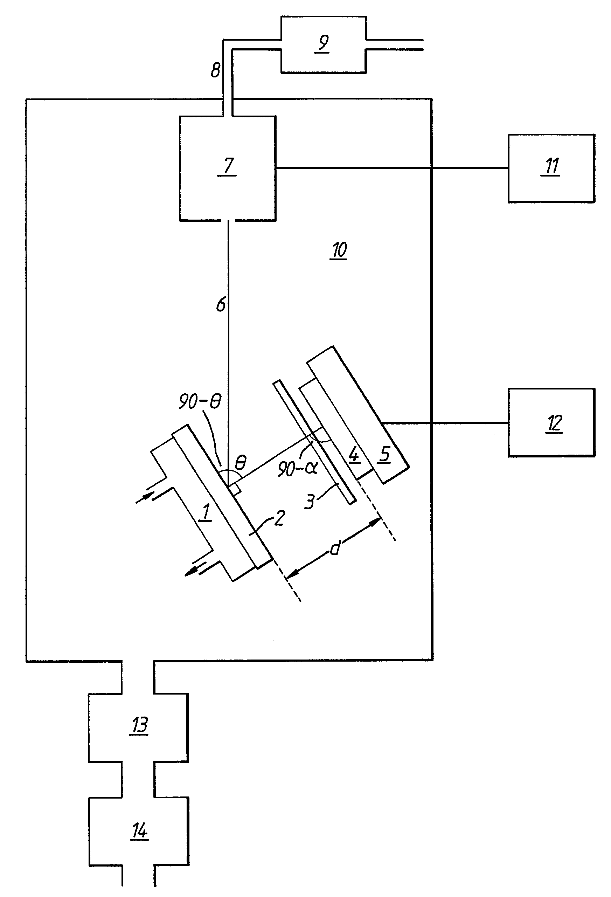

A diagram of the deposition apparatus is shown in Figure 1 and used to give the following detailed description of the formation of $Y_1Ba_2Cu_3O_{7\text{-}\delta}$ thin films from a target of composition $Y_1Ba_2Cu_3O_{7\text{-}\delta}$.

A $Y_1Ba_2Cu_3O_{7\text{-}\delta}$ ceramic target (2), mounted on a water cooled base (1), is positioned so that an ion beam (6) from an ion gun (7) impinges the target (2) centrally and at an angle $\theta$ to the target normal. A substrate (4) is mounted on a substrate heater (5) and positioned a distance d from the target (2) at an angle $\alpha$ to it, such that the correct geometry is achieved for the material sputtered from the target by the ion beam to impinge on the substrate (4).

A deposition chamber (10) is evacuated by a $LN_2$ cooled diffusion pump (13) backed by a rotary pump (14). Argon (8) controlled by a mass flow control system (9) is introduced into the chamber at the required pressure through the ion gun (7). A shutter (3) is placed across the substrate (4) to allow precleaning of the target (2) by the ion beam (6). The ion beam (6) is adjusted to the required power levels using power supply (11). Once the target is clean the substrate is heated to the required deposition temperature by heater (5) and control electronics (12). The shutter (3) is removed from over the substrate (4) to enable deposition to commence. The shutter (3) is replaced over the substrate (4) at the d the deposition. A post-deposition anneal of the $Y_1Ba_2Cu_3O_{7\text{-}\delta}$ film may be required to form the superconducting phase.

Typical deposition conditions are given in Table 1.

Table 1

| Typical Deposition Conditions | | |
|---|---|---|
| Deposition geometry | $\theta$ = | 65-80° |
| | $\alpha$ = | 0° |
| | d = | 50-150 mm |
| Deposition pressure | | 1.10-4 - 4.10-4 torr |
| Ion beam current | | 20 - 100 mA |
| Ion beam voltage | | 80° - 1800V |
| Substrate temperature | | 0 - 1000° C |
| Target pre-sputter time | | > 30 minutes, depending on target surface condition |

Although a preferred embodiment has been described, various modifications and variations may be envisaged.

Thus sputtering geometries other than that shown in figure 1 may be employed equally successfully

The ion beam gun may be replaced by a fast atomic beam gun. In addition, a further fast atomic beam or ion beams may be included to enable pre-cleaning of the substrate and surface stimulation of the growing film during deposition.

Inert gases other than argon may be employed to produce the ion beam.

Oxygen may be introduced into the system, either with the inert gas or independently, for example at the substrate surface.

Superconducting thin film compositions in the Y:Ba:Cu:O system having stoichiometric ratios other than $Y_1Ba_2Cu_3O_{7-\delta}$ could be fabricated using a single ceramic target of the desired film composition.

## Claims

1. A method of producing a superconducting thin film comprising providing a target of superconducting material in an evacuated chamber, providing a substrate positioned relative to the target to receive sputtered material from the target, and sputtering material from the target by means of a beam of ions or atoms whereby to form a film on the substrate of the same composition of material as that of the target.

2. A method as claimed in claim 1, wherein a beam of ions is employed for sputtering.

3. A method as claimed in claim 2, wherein a beam of argon ions is employed for sputtering.

4. A method as claimed in any preceding claim wherein the target material comprises a ceramic material.

5. A method as claimed in claim 4 wherein the ceramic material is of the form $A_aB_bCu_cD_d$, where A is any rare earth, B is an element in group IIa of the periodic table, and D is an element in period 2 of the periodic table.

6. A method as claimed in claim 5 wherein A is selected from yttrium, erbium, dysprosium, lanthanum or holmium, and/or B is selected from barium, strontium or calcium, and/or D is oxygen, nitrogen or fluorine.

7. A method as claimed in claim 6 wherein the material is yttrium barium copper oxide.

8. A method as claimed in claim 7 wherein the material has the stoichiometric composition $Y_1Ba_2Cu_3O_{7-\delta}$.

9. A method as claimed in any preceding claim wherein the film is subject to a subsequent annealing process.

10. A method as claimed in any preceding claim wherein a precleaning operation is carried out on the target.

11. A method as claimed in any preceding claim wherein an additional beam is employed for precleaning and surface stimulation of the film during deposition.

12. A method as claimed in claim 7 or 8 wherein oxygen is introduced into the evacuted chamber for adjustment of the oxygen content of the film.

13. A method as claimed in claim 1 wherein a fast atomic beam is employed for beam sputtering.

14. A method substantially as described with reference to the accompanying drawing of producing a superconducting thin film.

15. Apparatus for carrying out the method of claim 1, comprising an evacuable chamber, a target of superconducting material, means for producing a beam of ions, or atoms directed at the target, and a substrate positioned to receive target material sputtered from the target.

16. Apparatus as claimed in claim 15 wherein the beam producing means is an ion beam source.

17. Apparatus as claimed in claim 15 or 16 wherein the superconducting material is selected from any of the materials set forth in claims 4 to 8.

18. Apparatus as claimed in claim 15 including means for introducing oxygen into the chamber.

19. Apparatus as claimed in claim 15 including means for producing a further beam of ions, or atoms for stimulation of the surface of the deposited film.

20. Apparatus for producing a film of superconducting material substantially as described with reference to the accompanying drawing.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | JAPANESE JOURNAL OF APPLIED PHYSICS, vol. 26, no. 7, July 1987, pages L1199-1201, Tokyo, JP; O. MICHIKAMI et al.: "Synthesis of Y-Ba-Cu-O thin films on sapphire substrates by RF magnetron sputtering" * Page L1199, paragraphs 2-3 * | 1-9,12 | H 01 L 39/12 <br> H 01 L 39/24 |
| X | JAPANESE JOURNAL OF APPLIED PHYSICS, vol. 26, no. 7, July 1987, pages L1221-L1222, Tokyo, JP; H. ASANO et al.: "High Tc Y-Ba-Cu-O thin film prepared by dual magnetron sputtering" * Page L1221; abstract * | 1-9,12 | |
| X | JAPANESE JOURNAL OF APPLIED PHYSICS, vol. 20, supplement 20-4, 1981, pages 13-16, Tokyo, JP; M. SUZUKI et al.: "Thin film preparation of superconducting perovskite-type oxides by rf sputtering" * Page 13, column 2, paragraph 2; page 16, paragraph 2 * | 1-9,12 | **TECHNICAL FIELDS SEARCHED (Int. Cl.4)** <br><br> H 01 L 39 |
| P,X | EP-A-0 280 322 (SUMITOMO ELECTRIC INDUSTRIES LTD) * Column 3, lines 5-40 * | 1-9,12 | |

The present search report has been drawn up for all claims

| Place of search | Date of completion of the search | Examiner |
|---|---|---|
| THE HAGUE | 03-04-1989 | HAMMEL E.J. |